# EUROPEAN PATENT SPECIFICATION

(11) **EP 2 819 150 B1**
(45) Date of publication and mention of the grant of the patent: **27.09.2017**
(21) Application number: 14185469.5
(22) Date of filing: 12.04.2013
(51) Int. Cl.: H01L 21/306, H01L 21/67

(54) **Deposit removing method**
Ablagerungsbeseitigungsverfahren
Procédé de suppression de dépôt

(30) Priority: 18.04.2012 JP 2012094439; 24.04.2012 US 201261637385 P
(43) Date of publication of application: 31.12.2014
(62) Divisional of application: 13778233.0
(73) Proprietor: TOKYO ELECTRON LIMITED, Minato-ku Tokyo 107-6325 (JP)
(72) Inventor: Tahara, Shigeru, Kurokawa-gun, Miyagi 981-3629 (JP); Nishimura, Eiichi, Kurokawa-gun, Miyagi 981-3629 (JP)
(74) Representative: Manitz Finsterwald Patentanwälte PartmbB

(56) References cited:
- WO-A1-2012/153534
- US-A1- 2008 178 914
- US-A1- 2009 308 843
- US-A1- 2010 043 820
- US-B2- 6 936 193

## Description

### TECHNICAL FIELD

The embodiments described herein pertain generally to a deposit removing method.

### BACKGROUND

Conventionally, in the field of manufacturing semiconductor devices, a film forming process or an etching process is performed on a substrate such as a semiconductor wafer to form a desired pattern thereon. In such a manufacturing process of semiconductor devices, if a STI (Shallow Trench Isolation) process is performed, a deposit of silicon oxide (e.g., SiO₂ or SiOBr) may be deposited on a sidewall portion of the pattern. Conventionally, such a deposit is removed through a process using a HF single gas, for example.

If, however, a composition or a bonding state of the deposit is similar to that of silicon dioxide of a certain structure (*e.g*., a gate oxide film) in the pattern, there is a problem that selectivity therebetween may not be achieved. Further, water, which is a byproduct generated by a reaction (SiO₂ + 4HF → SiF₄ + 2H₂O) between the deposit and the HF gas, may accelerate the reaction to cause a chain reaction. As a result, the silicon dioxide of the structure in the pattern as well as the deposit may also be etched.

Moreover, if an exposure time during which the substrate is left after the etching process becomes longer, the selectivity may be further deteriorated by being affected by moisture depending on a moisture absorption state of the deposit.

A conventional deposit removing method of removing a deposit deposited on a surface of a pattern formed on a substrate in an etching process is described in document US 2010 / 0 043 820 A1. As a technique for removing a native oxide film formed on a surface of a silicon substrate, there is known a method of using HF vapor and H₂O or alcohol vapor from Japanese Patent Laid-open Publication No. H07-263416. However, this method is a technique for removing a native oxide film, and is not a technique for removing a deposit formed on a sidewall portion of a pattern.

As stated above, conventionally, when removing the deposit deposited on the pattern, there has been a problem that silicon dioxide of the structure in the pattern may be damaged because of low selectivity between the deposit and the silicon dioxide of the structure in the pattern. Further, if the exposure time after the etching process becomes longer, the selectivity may be further deteriorated by being affected by moisture depending on the moisture absorption state of the deposit.

Further, a deposit removing rate at a central portion of the substrate and a deposit removing rate at a peripheral portion of the substrate may easily get differed. As a result, it is difficult to improve processing uniformity in the entire surface of the substrate.

### SUMMARY

In view of the foregoing problems, example embodiments provide a deposit removing method capable of removing a deposit efficiently regardless of the length of the exposure time after an etching process, and, also, capable of removing the deposit uniformly while suppressing damage on silicon dioxide of a structure in a pattern.

In one example embodiment, a deposit removing method of removing a deposit deposited on a surface of a pattern formed on a substrate in an etching process includes performing an oxygen plasma process of exposing the substrate to oxygen plasma while heating the substrate; and performing a cycle process in which, after the performing of the oxygen plasma process, the substrate is exposed to an atmosphere of a mixture gas of a hydrogen fluoride gas and an alcohol gas within a processing chamber, and a first period during which a total pressure of the mixture gas or a partial pressure of the alcohol gas is set to be a first total pressure or a first partial pressure of the alcohol gas and a second period during which the total pressure of the mixture gas or the partial pressure of the alcohol gas is set to be a second total pressure lower than the first total pressure or a second partial pressure of the alcohol gas lower than the first partial pressure of the alcohol gas by evacuating the processing chamber are repeated multiple cycles. In the performing of the cycle process, the mixture gas is supplied to the substrate from a region facing the substrate, and a supply amount of the mixture gas per a unit area from a circular first region including a central portion of the substrate and having a diameter smaller than a diameter of the substrate is set to be larger than a supply amount of the mixture gas per a unit area from an annular second region at an outside of the first region.

In accordance with the example embodiments, it is possible to provide a deposit removing method capable of removing a deposit efficiently regardless of the length of exposure time after an etching process, and, also, capable of removing the deposit uniformly while suppressing silicon dioxide of a pattern structure from being damaged.

The foregoing summary is illustrative only and is not intended to be in any way limiting. In addition to the illustrative aspects, embodiments, and features described above, further aspects, embodiments, and features will become apparent by reference to the drawings and the following detailed description.

### BRIEF DESCRIPTION OF THE DRAWINGS

In the detailed description that follows, embodiments are described as illustrations only since various changes and modifications will become apparent to those skilled in the art from the following detailed description. The use of the same reference numbers in different figures indicates similar or identical items.
**FIG.1** is a schematic cross sectional configuration view of a plasma processing apparatus in accordance with an example embodiment;
**FIG. 2** is a schematic cross sectional configuration view of a gas processing apparatus in accordance with the example embodiment;
**FIG. 3A** and **FIG. 3B** are diagrams illustrating configuration of major components of the gas processing apparatus of **FIG. 2****;**
**FIG. 4** is a flowchart for describing a process sequence in the example embodiment;
**FIG. 5** is a graph showing a pressure variation in the example embodiment; and
**FIG. 6** is a graph showing a relationship between a pressure, a methanol gas flow rate and a temperature under which the deposit can be removed.

### DETAILED DESCRIPTION

In the following detailed description, reference is made to the accompanying drawings, which form a part of the description. In the drawings, similar symbols typically identify similar components, unless context dictates otherwise. Furthermore, unless otherwise noted, the description of each successive drawing may reference features from one or more of the previous drawings to provide clearer context and a more substantive explanation of the current example embodiment. Still, the example embodiments described in the detailed description, drawings, and claims are not meant to be limiting.

In the following, example embodiments will be described in detail, and reference is made to the accompanying drawings, which form a part of the description.

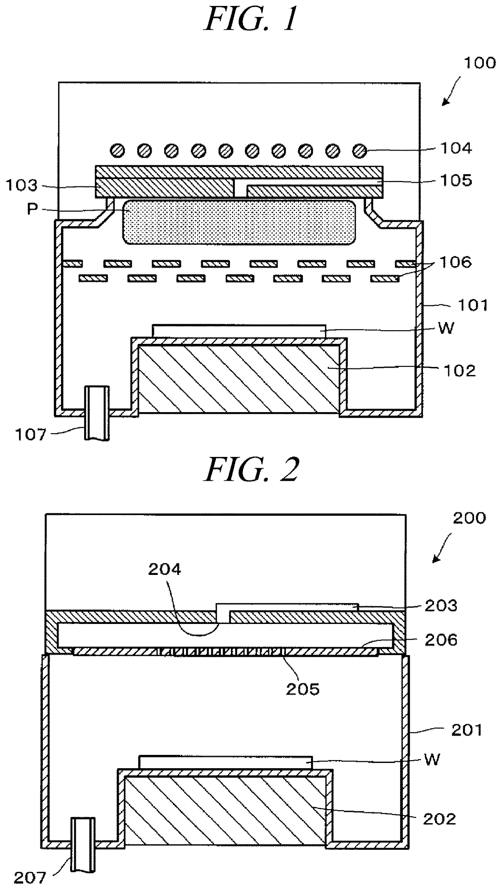

**FIG. 1** is a longitudinal cross sectional view schematically illustrating a configuration example of a plasma processing apparatus 100 to be used in an oxygen plasma process in a deposit removing method in accordance with an example embodiment. As depicted in **FIG. 1****,** the plasma processing apparatus 100 includes a processing chamber 101 configured to be hermetically sealed. The processing chamber 101 includes therein a stage 102 configured to mount thereon a semiconductor wafer (substrate) W. The stage 102 includes a non-illustrated temperature control device and is configured to control a temperature of the semiconductor wafer W mounted on the stage 102 to be a certain level.

The processing chamber 101 is made of, but not limited to, quartz. A window 103 made of quartz is provided at a ceiling portion of the processing chamber 101, and a RF coil 104 connected to a non-illustrated high frequency power supply is provided at the outside of the window 103. A gas inlet line 105, through which an oxygen-containing processing gas (*e.g.*, an O₂ single gas) is introduced into the processing chamber 101, is formed at a part of the window 103. The processing gas introduced through the gas inlet line 105 is excited into plasma P by applying a high frequency power to the RF coil 104.

Gas diffusion plates 106 for plasma shielding and gas dispersion are provided under the window 103. Through the gas diffusion plates 106, radicals in the plasma are supplied to the semiconductor wafer W on the stage 102 in a dispersed state. When allowing the plasma to act on a substrate, it may be possible to set the substrate and the plasma to be in direct contact with each other, or to perform a remote plasma process, as in the present example embodiment, in which the substrate and the plasma are not brought into direct contact with each other, but radicals separated from the plasma generated in a space distanced apart from the substrate are made to act on the substrate.

Further, a gas exhaust pipe 107 is provided at a bottom portion of the processing chamber 101. The gas exhaust pipe 107 is connected to a non-illustrated vacuum pump or the like and is configured to evacuate the chamber 101 to a preset pressure.

**FIG. 2** is a longitudinal cross sectional view schematically illustrating a configuration example of a gas processing apparatus 200 to be used in a cycle process in the deposit removing method in accordance with the example embodiment. As depicted in **FIG. 2****,** the gas processing apparatus 200 includes a processing chamber 201 configured to be hermetically sealed. The processing chamber 201 includes therein a stage 202 configured to mount thereon a semiconductor wafer (substrate) W. The stage 202 includes a non-illustrated temperature control device and is configured to control a temperature of the semiconductor wafer W mounted on the state 202 to be a preset level.

A gas inlet line 203, through which a preset processing gas (a mixture gas of a HF gas and a methanol gas in the present example embodiment) is introduced into the processing chamber 201, is formed at an upper portion of the processing chamber 201. Further, a gas diffusion plate 206 having a multiple number of through holes 205 is provided under an opening 204, at which the gas inlet line 203 is opened to an inside of the processing chamber 201, to face the semiconductor wafer W mounted on the stage 202. The processing gas is supplied onto a surface of the semiconductor wafer W from the through holes 205 of the gas diffusion plate 206, *i.e.,* from a region facing the semiconductor wafer W.

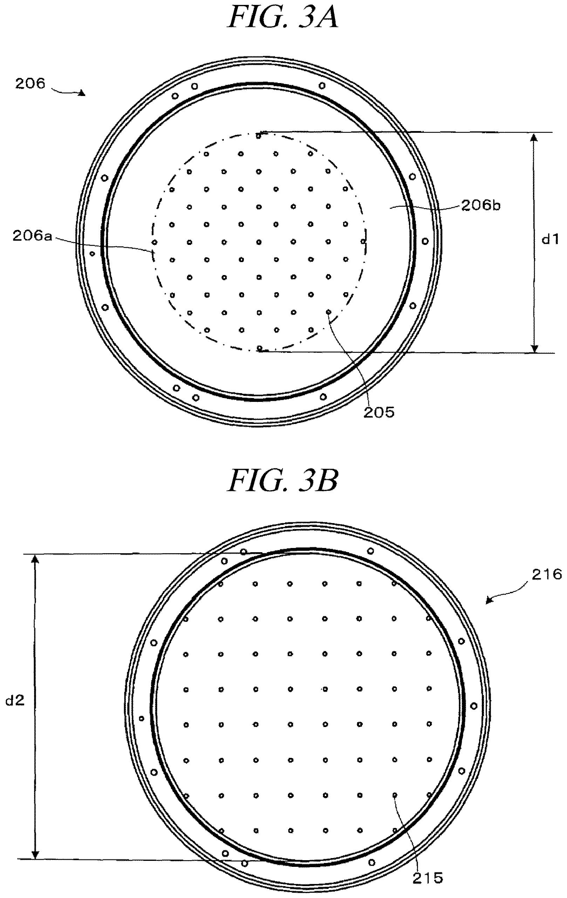

As shown in **FIG. 3A****,** for a semiconductor wafer W having a diameter of, *e.g*., 300 mm, the gas diffusion plate 206 has a circular first region 206a having a diameter of, *e.g*., 250 mm and an annular second region 206b at an outside of the first region 206a. The through holes 205 are formed in the circular first region 206a at a regular pitch, whereas no through hole 205 is formed in the annular second region 206b. With this configuration, among the regions facing the semiconductor wafer W, a flow rate of the processing gas supplied from the first region 206a per a unit area is set to be higher than a flow rate (zero (0) in the present example embodiment) of the processing gas supplied from the second region 206b per a unit area.

In **FIG. 3A****,** an imaginary line indicating a boundary between the first region 206a and the second region 206b is shown by a dashed dotted line. Further, **FIG. 3B** depicts a gas diffusion plate 216 having through holes 215 formed at a regular pitch in the entire surface thereof without separating a first region and a second region. The number of the through holes 205 in the gas diffusion plate 206 of **FIG. 3A** and the number of the through holes 215 in the gas diffusion plate 216 of **FIG. 3B** are same. The through holes 205 are formed at a pitch of, *e.g*., 28 mm, and the through holes 215 are formed at a pitch of, *e.g.,* 40 mm. Further, a diameter d2 of a region of the gas diffusion plate 216 in which the through holes 215 are arranged is set be to be, *e*.*g*., 345 mm, larger than the diameter of the semiconductor wafer W.

Additionally, in **FIG. 3A** and **FIG. 3B****,** the diameter d1 of the first region 206a and the diameter d2 of the region in which the through holes 215 are arranged indicate minimum diameters of circles drawn to include all the through holes 205 and all the through holes 215 therein, respectively. Further, in **FIG. 3A** and **FIG. 3B****,** the number of the through holes 205, the number of the through holes 215, the pitches between the through holes 205 and the pitches between the through holes 215 are not actual values, and illustration of some of them are omitted.

When using the gas diffusion plates 206 and 216, if a flow rate of the processing gas is, *e.g.,* 2800 sccm, a back pressure of the gas diffusion plates 206 and 216 may be, *e.g.,* 13.3 KPa (100 Torr). Meanwhile, an internal pressure of the processing chamber 201 in which the semiconductor wafer W is placed may be, *e.g*., 665 Pa (5 Torr). Since there is a great difference between the back pressure of the gas diffusion plates 206 and 216 and the internal pressure of the processing chamber 201, the processing gas may be discharged at a substantially uniform flow rate from the through holes 205 and 215 regardless of whether the through holes 205 and 215 are arranged at the central portion or the peripheral portion in the surface of the gas diffusion plates 206 and 216.

Referring back to **FIG. 2****,** a gas exhaust pipe 207 is provided at a bottom portion of the processing chamber 201. The gas exhaust pipe 207 is connected to a non-illustrated vacuum pump or the like, and is configured to evacuate the processing chamber 201 to a preset pressure.

In the present example embodiment, by using the plasma processing apparatus 100 and the gas processing apparatus 200 having the above-described configurations, a deposit removing process is performed as follows.

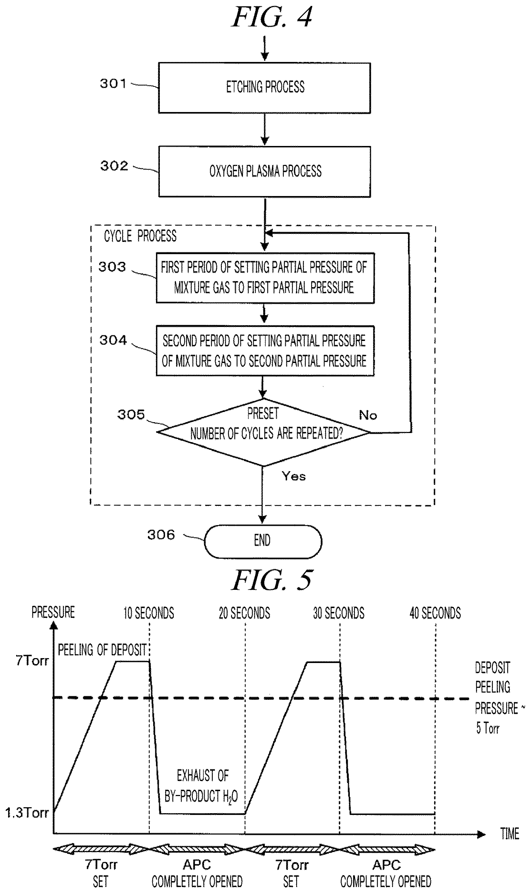

As depicted in a flowchart of **FIG. 4****,** an etching process is performed in a pretreatment (block 301), and a reaction product generated by the etching process is deposited on a sidewall portion of a pattern formed on a semiconductor wafer. By way of example, if a STI (Shallow Trench Isolation) process is performed, a deposit of silicon oxide (*e.g*., SiO₂ or SiOBr) is deposited on the sidewall portion of the pattern. Accordingly, the deposit deposited on the sidewall portion of the pattern is removed through the deposit removing process in accordance with the present example embodiment.

The aforementioned etching process (block 301) is performed by two processes as specified below.
(Process 1)
   Pressure: 6.65 Pa (50 mTorr)
   High frequency powers (high frequency)/ (low frequency): 400 W/ 1500 W
   Etching gas: HBr/ NF₃/ O₂ = 400 sccm/ 75 sccm/ 5 sccm
   Stage temperature: 110°C
   Time: 5 seconds
(Process 2)
   Pressure: 6.65 Pa (50 mTorr)
   High frequency powers (high frequency)/ (low frequency): 400 W/ 1400 W
   Etching gas: HBr/ NF₃/ O₂ = 350 sccm/ 32 sccm/ 19 sccm
   Stage temperature: 110°C
   Time: 20 seconds

After the etching process, an oxygen plasma process in the deposit removing process is performed (block 302). The oxygen plasma process may be performed in the plasma processing apparatus 100 shown in **FIG. 1** or the like. The deposit removing process may be performed immediately after the completion of the etching process or after a certain time (e.g., several hours to several days) has been elapsed.

The oxygen plasma process in the plasma processing apparatus 100 may be performed as follows, for example. That is, in the oxygen plasma process, a semiconductor wafer W is mounted on the stage 102 which is set to have a preset temperature previously. Then, by being attracted to and held by a non-illustrated electrostatic chuck or the like, the semiconductor wafer W is heated to a preset temperature. In this state, a processing gas containing an oxygen gas is introduced through the gas inlet line 105, and the processing chamber is evacuated through the gas exhaust pipe 107, so that an inside of the processing chamber 101 is turned into the processing gas atmosphere of a preset pressure. Then, as a high frequency power is applied to the RF coil 104, inductively coupled plasma of the oxygen gas is generated. Ions in this plasma are shielded by the gas diffusion plates 106, and oxygen radicals without having electric charges are supplied to the semiconductor wafer W on the stage 102 in a dispersed state. As a result, the oxygen plasma process with the oxygen radicals is performed.

This oxygen plasma process is performed to obtain constant moisture absorption states of the pattern and the deposit (*i.e.,* to dehydrate the pattern and the deposit) regardless of the length of the exposure time after the etching process. Accordingly, influence from the different moisture absorption states between the pattern and the deposit can be avoided in a subsequent cycle process. Thus, it is possible to remove the silicon oxide (*e.g*., SiO₂ or SiOBr), which is the deposit deposited on the sidewall portion of the pattern. Further, it is possible to suppress a SiO₂ layer of a gate oxide film or the like, which is a pattern structure, from being damaged due to the excessive reaction.

In this oxygen plasma process, an oxygen-containing gas such as, but not limited to, an oxygen single gas or a mixture gas of an oxygen gas and a nitrogen gas may be used as the processing gas. A heating temperature of the semiconductor wafer W (*i.e.,* stage temperature) may be set to be in the range from, e*.g.*, 200°C to 300°C. Further, the pressure may be set to be in the range from, *e.g*., 66.5 Pa (0.5 Torr) to 266 Pa (2 Torr).

After the oxygen plasma process as stated above, the cycle process in the deposit removing process is performed (blocks 303 to 305). This cycle process may be performed in the gas processing apparatus 200 depicted in **FIG. 2****.**

The cycle process in the gas processing apparatus 200 is performed as follows. That is, in the cycle process, the semiconductor wafer W is mounted on the stage 202 which is set to have a preset temperature previously, so that the semiconductor wafer W is maintained at a preset temperature. In this state, a certain processing gas (in this example embodiment, a HF gas + a methanol gas) is introduced through the gas inlet line 203, and the processing chamber is evacuated through the gas exhaust pipe 207, so that the inside of the processing chamber 201 is turned into the processing gas atmosphere of the preset pressure.

As shown in the flowchart of **FIG. 4****,** in the cycle process, a first period during which a partial pressure of the methanol gas is set to be a first partial pressure (block 303) and a second period during which the partial pressure of the methanol gas is set to be a second partial pressure lower than the first partial pressure by evacuating the inside of the processing chamber (block 304) are repeated multiple cycles (block 305). In order to vary the partial pressure of the methanol gas, the following methods may be utilized, for example.

First, a method of varying a gas supply may be used. For example, during the first period, a mixture gas of a preset flow rate is supplied, and then, during the second period, the supply of the mixture gas is stopped and a nitrogen gas of a certain flow rate is supplied. Alternatively, a method of varying a pressure may be used. For example, during the first period, while supplying the mixture gas of a preset flow rate, the inside of the processing chamber is maintained at a preset pressure by an automatic pressure controller (APC). Then, during the second period, by lowering a set pressure of the APC or by fully opening the APC, the entire processing chamber is evacuated by a vacuum pump, so that the pressure within the processing chamber is lowered. In the present example embodiment, as shown in **FIG. 5****,** the first period and the second period are set by using the method of the latter.

At this time, it may be desirable to set the temperature of the semiconductor wafer W to a low temperature equal to or less than, *e.g.,* several tens of degrees (*e.g.,* 30°C or less). Further, desirably, the pressure in the first period may be set to be in the range from, *e.g*., 665 Pa (5 Torr) to 1330 Pa (10 Torr), and a mixture gas of a HF gas and an alcohol gas (a CH₃OH gas in the present example embodiment) may be used as the processing gas.

In the first period of the cycle process, a pressure of the mixture gas or a partial pressure of the alcohol gas is set such that a deposit can be removed by the action of the mixture gas. Further, in the second period, the pressure of the mixture gas or the partial pressure of the alcohol gas is decreased so that the deposit is not removed but substances (H₂O, etc.) generated by a reaction between the deposit and the mixture gas during the first period is exhausted out of the processing chamber 201. The first period and the second period may be set to range from, e.g., 5 seconds to 20 seconds, respectively, and are repeated multiple cycles.

After repeating this cycle process preset number of times, the deposit removing process is ended (block 306).

In the above-described deposit removing process in accordance with the example embodiment, the constant moisture absorption states of the pattern and the deposit are obtained through the oxygen plasma process regardless of the length of the exposure time after the etching process.

In a process using a HF single gas, if the oxygen plasma process is performed, H₂O serving as a reaction accelerator is removed by performing the oxygen plasma process. Accordingly, a processing result may be stabilized, whereas it may be difficult to remove the deposit while obtaining selectivity against a SiO₂ film in the pattern structure. For this reason, in the cycle process in accordance with the present example embodiment, the mixture gas of the HF gas and the alcohol gas (methanol gas in the present example embodiment) is used as the processing gas. In this case, however, the amount of the H₂O generated by the reaction may become excessive within the processing chamber, so that a pattern structure such as a gate oxide film may be damaged or a deposit may be generated again as a result of a reverse reaction. To suppress this problem, through the cycle process, by repeating the first period during which the deposit is removed and the second period during which the deposit is not removed but the reaction product is exhausted, an excessive increase of the amount of the H₂O within the processing chamber can be suppressed.

Accordingly, it is possible to remove the silicon oxide (e.g., SiO₂ or SiOBr), which is the deposit deposited on the sidewall portion of the pattern. Further, it is possible to suppress a SiO₂ layer of the pattern structure such as the gate oxide film from being damaged as a result of the excessive reaction caused by a catalytic action by H₂O.

Further, in the present example embodiment, as for the semiconductor wafer W having a diameter of 300 mm, the gas diffusion plate 206 of the gas processing apparatus 200 has the through holes 205 formed at the uniform pitch in the circular first region 206a having a diameter of 250 mm, whereas no through hole 205 is formed in the annular second region 206b at the outside of the first region 206a, as shown in **FIG. 3A****.** With this configuration, among the regions facing the semiconductor wafer W, a flow rate of the processing gas supplied from the first region 206a per a unit area is set to be higher than a flow rate of the processing gas supplied from the second region 206b per a unit area. Accordingly, it is possible to perform the deposit removal process more uniformly in the entire surface of the semiconductor wafer W.

That is, as depicted in **FIG. 3B****,** for example, in case of using the gas diffusion plate 216 having the through holes 215 formed at the uniform pitch in the entire surface without separating the first region and the second region substantially, a deposit removing rate at a central portion of the semiconductor wafer W may become increased, and a deposit removing rate at a peripheral portion of the semiconductor wafer W becomes decreased. That is, a processing rate in the entire surface of the semiconductor wafer W may become non-uniform. This phenomenon occurs when a pattern is formed on the semiconductor wafer W. When etching a so-called beta film without having a pattern formed on a semiconductor wafer W, an etching rate at a peripheral portion of the semiconductor wafer W may become higher than an etching rate at a central portion thereof.

As stated above, the reason why the reverse phenomena take place in the respective cases where the pattern is formed on the semiconductor wafer W and the pattern is not formed on the semiconductor wafer W is deemed to be as follows. That is, a gas velocity above the central portion of the semiconductor wafer W is lower than a gas velocity above an edge portion thereof, and H₂O, which is generated as a result of the reaction, may not be efficiently exhausted from an inside of the pattern but may stay within the pattern. As a result, the reaction may progress through a catalytic reaction by the H₂O. Accordingly, by setting a supply amount of the processing gas to the central portion of the semiconductor wafer W per a unit area to be larger than a supply amount of the processing gas to the edge portion per a unit area, *i.e.,* by increasing the gas velocity above the central portion of the semiconductor wafer W, exhaust of the H₂O from the inside of the pattern at the central portion of the semiconductor wafer W may be accelerated, so that the processing uniformity in the entire surface of the semiconductor wafer W may be improved.

Further, in the example shown in **FIG. 3A****,** no through hole 205 is formed in the second region 206b at the outside of the first region 206a. However, it may be possible to adopt a configuration in which the through holes 205 are formed in the second region 206b at an arrangement density (the number of the through holes per a unit area) lower than that of the first region 206a. Further, without changing the arrangement density of the through holes 205, it may be also possible to adopt a configuration in which the supply amounts of the processing gas in the first region 206a and the second region 206b are independently changed. As a result, the supply amount of the processing gas from the first region 206a per a unit area may be set to be larger than the supply amount of the processing gas from the second region 206b per a unit area. Further, the diameter d1 of the first region 206a needs to be set to be smaller than the diameter of the semiconductor wafer W. Desirably, the diameter d1 may be set to range from 70% to 90% of the diameter of the semiconductor wafer W inclusive, and, more desirably, 75% to 85% inclusive. Additionally, in the configuration where the through holes 205 are formed in the second region 206b, the outer diameter of the second region 206b may be set to be larger than the diameter of the semiconductor wafer W.

As an experimental example 1, a deposit removing process is performed on a semiconductor wafer W left for 1 month after forming a pattern thereon by the etching. First, the oxygen plasma process is performed under the following processing conditions.
Pressure: 133 Pa (1 Torr)
High frequency power: 1000 W
Etching gas:O₂ = 1980 sccm
Stage temperature: 250°C
Time: 120 seconds

Subsequently, the cycle process is performed under the processing conditions as follows.
Pressure: (931 Pa (7 Torr) for 10 seconds ⇔ 173 Pa (1.3 Torr) for 10 seconds) x 6 cycles
HF/CH₃OH = 2800 sccm/44 sccm
Stage temperature: 10°C

As for the setting of the pressure in the aforementioned cycle process, as stated above, a state in which the set pressure of the APC is set to be 931 Pa (7 Torr) is maintained for 10 seconds during the first period, and, a state in which the APC is fully opened while supplying the processing gas is maintained for 10 seconds during the second period. An actual pressure variation in the processing chamber 201 is as shown in a graph of **FIG. 5**. That is, even if the set pressure of the APC is set to be 931 Pa (7 Torr) from the state in which the APC is fully opened, it takes 4 seconds to 5 seconds until the pressure actually reaches 931 Pa (7 Torr). Meanwhile, if the APC is fully opened from the state in which the set pressure of the APC is 931 Pa (7 Torr), the pressure may maintain at a constant level of 173 Pa (1.3 Torr) in a relatively short period of time.

Here, under the above-mentioned conditions for the stage temperature and the flow rate of the processing gas, the pressure at which the deposit can be removed (the deposit is peeled off) is 665 Pa (5 Torr). Accordingly, the time corresponding to the 1/2 cycle in the cycle process may be set to range from, *e.g*., 5 seconds to 20 seconds, desirably. Further, the first period and the second period are not necessarily the same but may be different from each other.

The semiconductor wafer after the above-described deposit removing process is observed while enlarged by a SEM. As a result, the deposit deposited on the sidewall portion of the pattern is found to be removed, and no damage on the SiO₂ layer of the pattern structure such as the gate oxide film is observed.

Meanwhile, as a comparative example 1, the same gas process as the experimental example 1 is performed by using a HF single gas after the oxygen plasma process in the first example embodiment, and the deposit is hardly removed.

Now, a result of investigating processing conditions under which the deposit can be removed will be explained. First, a relationship between an amount of the methanol gas added to the processing gas and a peeling force for the deposit is investigated. As compared to a sample in which the deposit is not removed since the methanol gas is not added, it is observed that the deposit is removed in case of adding the methanol gas of, *e.g.,* 100 sccm. Further, if the addition amount of the methanol gas is increased to, *e.g.,* 200 sccm, the peeling force is enhanced. In this experiment, however, since the gas process is continually performed without performing the cycle process, the gate oxide film which is the pattern structure is etched and damaged.

Additionally, in order to investigate a relationship between the pressure of the processing gas and the peeling force for the deposit, the deposit of the sample is removed by setting the pressure to, e.g., 665 Pa (5 Torr), 1330 Pa (10 Torr) and 1995 Pa (15 Torr), respectively. As a result, it is observed that the peeling force for the deposit is increased with the rise of the pressure. In this experiment, however, since the gas process is continually performed without performing the cycle process, the gate oxide film which is the pattern structure is etched and damaged.

Further, in order to investigate a relationship between the temperature and the peeling force for the deposit, the deposit of the sample is removed by setting the temperature to 10°C, 30°C and 50°C, respectively. As a result, it is found out that the peeling force for the deposit is increased as the temperature decreases. In this experiment, however, since the gas process is continually performed without performing the cycle process, the gate oxide film which is the pattern structure is etched and damaged.

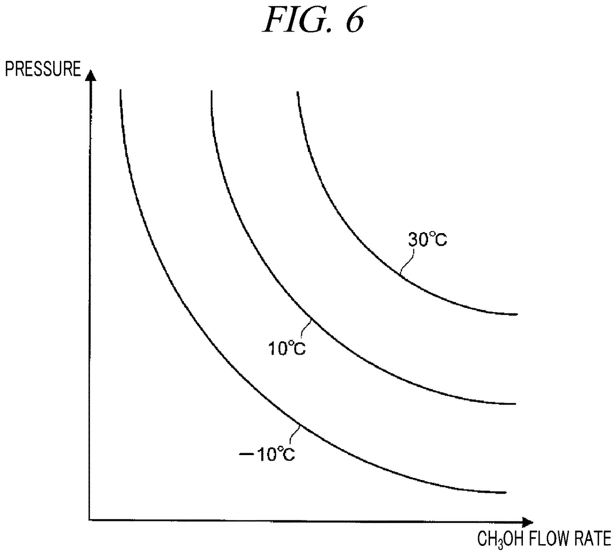

From the above results, it is possible to determine a boundary line, for each of the processing temperatures, between a region in which the deposit removal progresses and a region in which the deposit removal does not progress, as depicted in a graph of **FIG. 6** in which a vertical axis represents a pressure and a horizontal axis indicate a flow rate of a methanol gas. If a processing condition (either one of or both of a total pressure and the flow rate of the methanol gas) is changed to pass the boundary line, it is possible to set the first period during which the deposit is removed and the second period during which the deposit is not removed in the cycle process.

Now, a result of investigating uniformity in the entire surface of the wafer of the deposit removing process will be discussed. As an experimental example 2, the above-described deposit removing process is performed on a semiconductor wafer W, in which a line and space pattern is formed and a deposit is deposited in spaces between the lines, by using the gas processing apparatus 200 equipped having the gas diffusion plate 206 shown in **FIG. 3A****.** Then, depths of the spaces between the lines are measured. The depths of the spaces are measured at a central portion and an intermediate portion of the semiconductor wafer W, and at positions of 30 mm and 4 mm away from an edge of the semiconductor wafer W, respectively. As a result, the depths are measured as follows:
central portion = 107.2 nm
intermediate portion = 75.4 nm
position of 30 mm away from the edge = 74.1 nm
position of 4 mm away from the edge = 75.4 nm
Accordingly, a depth difference between the central portion of the semiconductor wafer W and the position of 4 mm from the edge of the semiconductor wafer W is 31.8 nm.

Meanwhile, as a comparative example 2, the above-described deposit removing process is performed on a semiconductor wafer W, in which a line and space pattern is formed and a deposit is deposited in spaces between the lines, by using the gas processing apparatus 200 having the gas diffusion plate 216 shown in **FIG. 3B****.** Then, depths of the spaces between the lines are measured. In this comparative example 2, the deposit removing process is performed under the same conditions as those of the experimental example 2, excepting that the gas diffusion plate 216 is used. The depths of the spaces are measured at a central portion and an intermediate portion of the semiconductor wafer W, and at positions of 30 mm and 4 mm away from an edge of the semiconductor wafer W, respectively. As a result, the depths are measured as follows:
central portion = 111.1 nm
intermediate portion = 71.4 nm
position of 30 mm away from the edge = 67.5 nm
position of 4 mm away from the edge = 66. 2 nm
Accordingly, a depth difference between the central portion of the semiconductor wafer W and the position of 4 mm from the edge of the semiconductor wafer W is 44.9 nm.

As can be clearly seen from the above results, in the experimental example 2, uniformity of the deposit removing process in the entire surface of the semiconductor wafer W is found to be improved, as compared to the case of the comparative example 2.

From the foregoing, it will be appreciated that various embodiments of the present disclosure have been described herein for purposes of illustration and are not intended to be limiting, and that various modifications may be made. By way of example, the above example embodiment and experimental examples have been described for the case of using the methanol gas as the alcohol gas, other types of alcohol gases, such as an ethanol gas or an isopropyl alcohol gas, may be utilized.

The example embodiment may be applicable to the field of manufacture of semiconductor devices, and, thus, has industrial applicability.

## Claims

1. A deposit removing method of removing a deposit deposited on a surface of a pattern formed on a substrate (W) in an etching process, the deposit removing method comprising:
performing an oxygen plasma process of exposing the substrate (W) to an oxygen-containing plasma while heating the substrate (W); and
performing a cycle process in which, after the performing of the oxygen plasma process, the substrate (W) is exposed to an atmosphere of a mixture gas of a hydrogen fluoride gas and an alcohol gas within a processing chamber (101), and a first period during which a total pressure of the mixture gas or a partial pressure of the alcohol gas is set to be a first total pressure or a first partial pressure of the alcohol gas and a second period during which the total pressure of the mixture gas or the partial pressure of the alcohol gas is set to be a second total pressure lower than the first total pressure or a second partial pressure of the alcohol gas lower than the first partial pressure of the alcohol gas by evacuating the processing chamber (101) are repeated multiple cycles,
wherein in the performing of the cycle process, the mixture gas is supplied to the substrate (W) from a region facing the substrate (W), and a supply amount of the mixture gas per a unit area from a circular first region (206a) including a central portion of the substrate (W) and having a diameter smaller than a diameter of the substrate (W) is set to be larger than a supply amount of the mixture gas per a unit area from an annular second region (206b) at an outside of the first region (206a).

2. The deposit removing method of Claim 1,
wherein the diameter of the first region (206a) is equal to or less than 85% of the diameter of the substrate (W).

3. The deposit removing method of Claim 1 or 2,
wherein the deposit is removed by an action of the mixture gas under the first partial pressure.

4. The deposit removing method of any one of Claims 1 to 3,
wherein the first period and the second period are set to be in a range from 5 seconds to 20 seconds, respectively.

5. The deposit removing method of any one of Claims 1 to 4,
wherein the deposit contains silicon oxide.

6. The deposit removing method of any one of Claims 1 to 5,
wherein the substrate contains silicon dioxide as a structure.

7. The deposit removing method of any one of Claims 1 to 6,
wherein the alcohol gas is a methanol gas.

## Patentansprüche

1. Abscheidungsentfernungsverfahren zum Entfernen einer Abscheidung, die an einer Fläche eines Musters abgeschieden ist, das an einem Substrat (W) in einem Ätzprozess gebildet ist, wobei das Abscheidungsentfernungsverfahren umfasst:
Ausführen eines Sauerstoffplasmaprozesses, um das Substrat (W) einem sauerstoffhaltigen Plasma auszusetzen, während das Substrat (W) erwärmt wird; und
Ausführen eines Zyklusprozesses, bei dem nach der Ausführung des Sauerstoffplasmaprozesses das Substrat (W) einer Atmosphäre eines Gemischgases eines Wasserstofffluoridgases und eines Alkoholgases in einer Prozesskammer (101) ausgesetzt wird, und einer ersten Periode, während der ein Gesamtdruck des Gemischgases oder ein Teildruck des Alkoholgases auf einen ersten Gesamtdruck oder einen ersten Teildruck des Alkoholgases gesetzt wird, und einer zweiten Periode, während der der Gesamtdruck des Gemischgases oder der Teildruck des Alkoholgases auf einen zweiten Gesamtdruck, der geringer als der erste Gesamtdruck ist, oder einen zweiten Teildruck des Alkoholgases gesetzt wird, der geringer als der erste Teildruck des Alkoholgases ist, indem ein Evakuieren der Prozesskammer (101) mehrere Zyklen wiederholt wird,
wobei bei der Ausführung des Zyklusprozesses das Gemischgas an das Substrat (W) von einem Bereich, der zu dem Substrat (W) weist, geliefert wird, und eine Liefermenge des Gemischgases pro Flächeneinheit von einem kreisförmigen ersten Bereich (206a), der einen Zentralbereich des Substrats (W) aufweist und einen Durchmesser besitzt, der kleiner als ein Durchmesser des Substrats (W) ist, auf größer als eine Liefermenge des Gemischgases pro einer Flächeneinheit von einem ringförmigen zweiten Gebiet (206b) an einer Außenseite des ersten Gebiets (206a) eingestellt wird.

2. Abscheidungsentfernungsverfahren nach Anspruch 1,
wobei der Durchmesser des ersten Gebiets (206a) gleich oder kleiner als 85% des Durchmessers des Substrats (W) ist.

3. Abscheidungsentfernungsverfahren nach einem der Ansprüche 1 oder 2,
wobei die Abscheidung durch eine Wirkung des Gemischgases unter dem ersten Teildruck entfernt wird.

4. Abscheidungsentfernungsverfahren nach einem der Ansprüche 1 bis 3,
wobei die erste Periode und die zweite Periode jeweils in einem Bereich zwischen 5 Sekunden und 20 Sekunden eingestellt sind.

5. Abscheidungsentfernungsverfahren nach einem der Ansprüche 1 bis 4,
wobei die Abscheidung Siliziumoxid enthält.

6. Abscheidungsentfernungsverfahren nach einem der Ansprüche 1 bis 5,
wobei das Substrat Siliziumdioxid als eine Struktur enthält.

7. Abscheidungsentfernungsverfahren nach einem der Ansprüche 1 bis 6,
wobei das Alkoholgas ein Methanolgas ist.

## Revendications

1. Procédé de suppression de dépôt pour supprimer un dépôt déposé sur une surface d'un motif formé sur un substrat (W) dans un processus d'attaque chimique, le procédé de suppression de dépôt comprenant les étapes consistant à :
exécuter un processus à plasma d'oxygène consistant à exposer le substrat (W) à un plasma contenant de l'oxygène, tout en chauffant le substrat (W) ; et
exécuter un processus en cycle dans lequel, après exécution du processus à plasma d'oxygène, le substrat (W) est exposé à une atmosphère d'un mélange gazeux constitué de fluorure d'hydrogène gazeux et d'un alcool gazeux à l'intérieur d'une chambre de traitement (101), et une première période pendant laquelle une pression totale du mélange gazeux ou une pression partielle de l'alcool gazeux est fixée pour être une première pression totale ou une première pression partielle de l'alcool gazeux, et une seconde période pendant laquelle la pression totale du mélange gazeux ou la pression partielle de l'alcool gazeux est fixée pour être une seconde pression totale plus basse que la première pression totale ou une seconde pression partielle de l'alcool gazeux est plus basse que la première pression partielle de l'alcool gazeux en évacuant la chambre de traitement (101) sont répétées pendant une multiplicité de cycles,
dans lequel, lors de l'exécution du processus en cycle, le mélange gazeux est fourni au substrat (W) depuis une région en face du substrat (W), et une quantité fournie de mélange gazeux par unité de surface depuis une première région circulaire (206a) incluant une portion centrale du substrat (W) et ayant un diamètre plus petit qu'un diamètre du substrat (W) est fixée pour être plus élevée qu'une quantité fournie de mélange gazeux par unité de surface depuis une seconde région annulaire (106b) à l'extérieur de la première région (206a).

2. Procédé de suppression de dépôt selon la revendication 1,
dans lequel le diamètre de la première région (206a) est égal ou inférieur à 85 % du diamètre du substrat (W).

3. Procédé de suppression de dépôt selon la revendication 1 ou 2,
dans lequel le dépôt est supprimé par une action du mélange gazeux sous la première pression partielle.

4. Procédé de suppression de dépôt selon l'une quelconque des revendications 1 à 3,
dans lequel la première période et la seconde période sont fixées pour tomber dans une plage de 5 secondes à 20 secondes, respectivement.

5. Procédé de suppression de dépôt selon l'une quelconque des revendications 1 à 4,
dans lequel le dépôt contient de l'oxyde de silicium.

6. Procédé de suppression de dépôt selon l'une quelconque des revendications 1 à 5,
dans lequel le substrat contient du dioxyde de silicium en tant que structure.

7. Procédé de suppression de dépôt selon l'une quelconque des revendications 1 à 6,
dans lequel l'alcool gazeux est du méthanol gazeux.
